# EUROPEAN PATENT SPECIFICATION

(11) **EP 4 155 954 B1**
(45) Date of publication and mention of the grant of the patent: **02.12.2026**
(21) Application number: 22182952.6
(22) Date of filing: 05.07.2022
(51) Int. Cl.: G06F 13/40, H10W 72/90, H10P 74/00, H10W 72/29, H10W 80/00, H10W 90/00, H10W 90/28

(54) **TEST AND DEBUG SUPPORT WITH HBI CHIPLET ARCHITECTURE**
TEST- UND DEBUG-UNTERSTÜTZUNG MIT HBI-CHIPLET-ARCHITEKTUR
SUPPORT DE TEST ET DÉBOGAGE AVEC ARCHITECTURE DE MICROPUCES HBI

(30) Priority: 24.09.2021 US 202117485211
(43) Date of publication of application: 29.03.2023
(73) Proprietor: Intel Corporation, Santa Clara, CA 95054 (US)
(72) Inventor: PASDAST, Gerald, San Jose, 95120 (US); TIAGARAJ, Sathya, San Jose, 95119 (US); ELSHERBINI, Adel, Tempe, 85284 (US); KARNIK, Tanay, Portland, 97229 (US); MUNOZ, Robert, Round Rock, 78681 (US); STAFFORD, Kevin, Fort Collins, 80528 (US)
(74) Representative: Goddar, Heinz J.

(56) References cited:
- US-A1- 2012 098 140
- US-A1- 2019 319 626
- US-A1- 2021 098 407
- US-A1- 2021 098 422
- US-A1- 2021 098 440
- US-A1- 2021 159 163

## Description

### TECHNICAL FIELD

Embodiments of the present disclosure relate to electronic packages, and more particularly to electronic packages with test and/or debug chiplets that are attached with a hybrid bonding interconnect (HBI) architecture.

### BACKGROUND

There is a practical limitation to the number of view ports in a microchip. There is also a practical limitation to the number of signals/nodes that can be effectively routed to each of the mentioned view IO ports. This leads the microchip designers to limit the number of nodes within the microchip that can be viewed directly by testing equipment. Often, these limitations make post silicon testing and debugging more difficult and take a relatively long time. As such, there can be delays in time to market upon the arrival of the first silicon. In some instances test engineers rely on focused ion beam (FIB) to generate probe points within the die that do not have view pins/visibility muxed out in the design. However, such FIB processes are time consuming and expensive.

US 2021/098440 A1 discloses: Techniques and mechanisms for providing at a packaged device an integrated circuit (IC) chip and a chiplet, wherein memory resources of the chiplet are accessible by a processor core of the IC chip. In an embodiment, a hardware interface of the packaged device includes first conductive contacts at a side of the chiplet, wherein second conductive contacts of the hardware interface are electrically interconnected to the IC chip each via a respective path which is independent of the chiplet. In another embodiment, one or more of the first conductive contacts are configured to deliver power, or communicate a signal, to a device layer of one of the IC chip or the chiplet.

US 2021/098422 A1 discloses: Composite IC chip including a chiplet embedded within metallization levels of a host IC chip. The chiplet may include a device layer and one or more metallization layers interconnecting passive and/or active devices into chiplet circuitry. The host IC may include a device layer and one or more metallization layers interconnecting passive and/or active devices into host chip circuitry. Features of one of the chiplet metallization layers may be directly bonded to features of one of the host IC metallization layers, interconnecting the two circuitries into a composite circuitry. A dielectric material may be applied over the chiplet. The dielectric and chiplet may be thinned with a planarization process, and additional metallization layers fabricated over the chiplet and host chip, for example to form first level interconnect interfaces. The composite IC chip structure may be assembled into a package substantially as a monolithic IC chip.

US 2021/098407 A1 discloses: A composite integrated circuit (IC) device structure comprising a host chip and a chiplet. The host chip comprises a first device layer and a first metallization layer. The chiplet comprises a second device layer and a second metallization layer that is interconnected to transistors of the second device layer. A top metallization layer comprising a plurality of first level interconnect (FLI) interfaces is over the chiplet and host chip. The chiplet is embedded between a first region of the first device layer and the top metallization layer. The first region of the first device layer is interconnected to the top metallization layer by one or more conductive vias extending through the second device layer or adjacent to an edge sidewall of the chiplet.

US 2021/159163 A1 discloses: An integrated circuit (IC) device structure, comprising a host chip having a device layer and one or more first metallization levels over adjacent first and second regions of the device layer. The first metallization levels are interconnected to the device layer. An interconnect chiplet is over the first metallization levels within the first region. The interconnect chiplet comprises a plurality of second metallization levels, and a plurality of third metallization levels over the first metallization levels within the second region and adjacent to the interconnect chiplet. At least one of an interconnect feature dimension or composition differs between one of the second metallization levels and an adjacent one of the third metallization levels.

US 2012/098140 A1 discloses: A circuit arrangement and method utilize hybrid bonding techniques that combine wafer-wafer bonding processes with chip-chip and/or chip-wafer bonding processes to form a multi-layer semiconductor stack, e.g., by bonding together one or more sub-assemblies formed by wafer-wafer bonding together with other sub-assemblies and/or chips using chip-chip and/or chip-wafer bonding processes. By doing so, the advantages of wafer-wafer bonding techniques, such as higher interconnect densities, may be leveraged with the advantages of chip-chip and chip-wafer bonding techniques, such as mixing and matching chips with different sizes, aspect ratios, and functions.

US 2019/319626 A1 discloses multi-chip systems and structures for modular scaling. In some embodiments an interfacing bar is utilized to couple adjacent chips. For example, a communication bar may utilized to coupled logic chips, and memory bar may be utilized to couple multiple memory chips to a logic chip.

The invention is set out in the appended claims.

### BRIEF DESCRIPTION OF THE DRAWINGS

Figure 1A is a plan view illustration of a die with a plurality of functional blocks, in accordance with an embodiment.
Figure 1B is a plan view illustration of a die with a plurality of functional blocks and an array of hybrid bonding interconnect (HBI) pads over a surface of the die, in accordance with an embodiment.
Figure 1C is a plan view illustration of a die with HBI pads over one of the functional blocks of the die, in accordance with an embodiment.
Figure 1D is a plan view illustration of a die with uniform HBI pads over each of the functional blocks of the die, in accordance with an embodiment.
Figure 2 is a cross-sectional illustration of a test chiplet, in accordance with an embodiment.
Figure 3 is a cross-sectional illustration of the HBI interface between a test chiplet and a die, in accordance with an embodiment.
Figure 4A is a cross-sectional illustration of a die with a test chiplet attached, in accordance with an embodiment.
Figure 4B is a cross-sectional illustration of a die with the test chiplet removed, in accordance with an embodiment.
Figure 5A is a cross-sectional illustration of a die with a test chiplet attached to a backside surface of the die, in accordance with an embodiment.
Figure 5B is a cross-sectional illustration of a die with a test chiplet attached to a backside surface of the die, where additional HBI pads are left unconnected, in accordance with an embodiment.
Figure 6A is a cross-sectional illustration of an electronic system with a die that includes a test chiplet, in accordance with an embodiment.
Figure 6B is a cross-sectional illustration of an electronic system with a test chiplet on the backside of the electronic system.
Figure 7 is a schematic of a computing device built in accordance with an embodiment.

### EMBODIMENTS OF THE PRESENT DISCLOSURE

Described herein are electronic packages with test and/or debug chiplets that are attached with a hybrid bonding interconnect (HBI) architecture, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

As noted above, there is a practical limit to the number of view ports in a microchip. Accordingly, test and debug processes can be extremely challenging. In some instances focused ion beam (FIB) processes are needed to generate pads to regions that are not serviced by existing DFx hooks. Accordingly, embodiments disclosed herein include the use of hybrid bonding interconnect (HBI) architectures in order to generate the DFx hooks on the die. The use of HBI architectures is particularly beneficial because the pads have a much smaller size and pitch. As such, there is support for a significantly higher number of nodes within the die without having to rout/mux all of them to a view pin or pins. One can simply add an HBI pad to all desired nodes. In post silicon testing, special assemblies can be fabricated with probe chiplets (connected by HBI, so as to allow inclusion with minimal resource allocation) to provide views for desired nodes. The HBI architecture allows for more DFx hooks to be provided on the die. The DFx hooks can be coupled to a test chiplet using the HBI architectures. In some embodiments, the test chiplets are kept on the die, and in other embodiments, the test chiplets are removed from the die before sale to the customer.

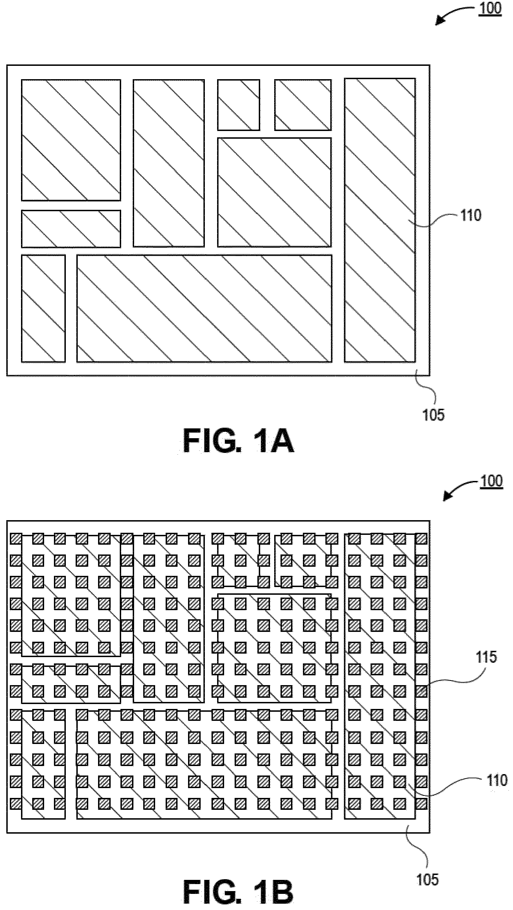

Referring now to Figure 1A, a plan view illustration of a die 100 is shown, in accordance with an embodiment. In an embodiment, the die 100 may comprise a substrate 105. The substrate 105 may be a silicon substrate or any other semiconductor substrate. The substrate 105 may comprise a plurality of functional blocks 110. As shown, the functional blocks 110 may have different dimensions and orientations across the surface of the substrate 105. In an embodiment, the functional blocks 110 may comprise any functional block typical of a die. For example, the functional blocks 110 may comprise a processor core, a memory block, IO blocks, and the like. In a particular embodiment, the die 100 may be considered a system on a chip (SOC). Though, it is to be appreciated that other types of dies 100 may be used in accordance with embodiments disclosed herein.

Referring now to Figure 1B, a plan view illustration of a die 100 is shown, in accordance with an additional embodiment. In an embodiment, the die 100 may be substantially similar to the die 100 described above with respect to Figure 1A. For example, the die 100 may comprise a substrate 105 and functional blocks 110. Additionally, the die 100 comprises an array of HBI pads 115. Each of the HBI pads 115 may be coupled to a node within the die 100. In other embodiments, multiple nodes may be muxed to a single HBI pad 115.

The HBI pads 115 may be formed in a regular array across a surface of the die 100. In an embodiment, the HBI pads 115 are formed over the backside surface of the die 100. That is, the HBI pads 115 are opposite from the first level interconnects (FLIs) (not shown in Figure 1B). However, in other embodiments, HBI pads 115 may also be formed on the FLI side of the die 100, as will be described in greater detail below.

In an embodiment, the HBI pads 115 have a pitch and size that allows for more HBI pads 115 than what is possible with existing DFx hooks. While shown as a 13x19 array in Figure 1B, it is to be appreciated that thousands or tens of thousands of the HBI pads 115 may be provided across the die 100. For example, the HBI pads 115 may have a pitch P that is approximately 20µm or less, or approximately 10µm or less. As used herein, "approximately" refers to a range of values within 10% of the stated value. For example, "approximately 10µm" may refer to a range that is between 9µm and 11µm.

In the illustrated embodiment, the HBI pads 115 have a regular array with columns and rows. The array of the HBI pads 115 may include HBI pads 115 that are not directly over one of the functional blocks 110. For example, HBI pads 115 may be over an edge of an underlying functional block 110 or entirely outside of footprints of underlying functional blocks 110.

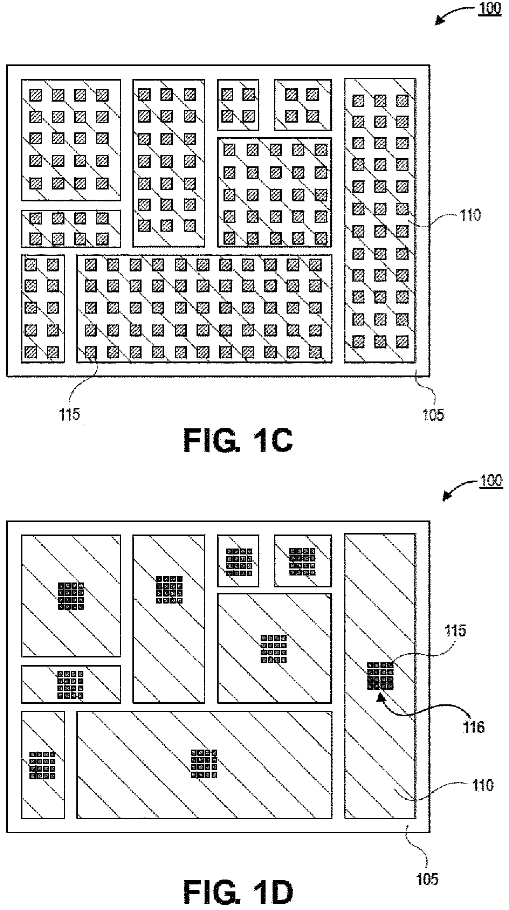

Referring now to Figure 1C, a plan view illustration of a die 100 is shown, in accordance with an embodiment. In an embodiment, the die 100 may be substantially similar to the die 100 in Figure 1A. That is, the die 100 may comprise a substrate 105 and a plurality of functional blocks 110. In an embodiment, an array of HBI pads 115 may be formed over the die 100. In an embodiment, the HBI pads 115 may be formed over a backside of the die 100 opposite from the FLI side. In other embodiments, the HBI pads 115 may be provided over the FLI side, as will be described in greater detail below.

In contrast to the embodiment shown in Figure 1B, the array of HBI pads 115 includes separate sub-arrays over each of the functional blocks 110. That is, each subarray of the HBI pads 115 are provided over one of the functional blocks 110. That way, test chiplets (described in greater detail below) may be coupled to the functional block 110 that is being investigated. In an implementation, the HBI pads 115 for each functional block 110 may be substantially similar. That is, the pitch and size of the HBI pads 115 may be the same for each functional block 110. In other implementations, like the embodiments defined in claims 1 and 9, the HBI pads 115 have different sizes and/or pitches depending on which functional block 110 the HBI pad 115 is servicing.

Referring now to Figure 1D, a cross-sectional illustration of a die 100 is shown, in accordance with an additional embodiment. In an embodiment, the die 100 may comprise a substrate 105 with a plurality of functional blocks 110. The die 100 may be substantially similar to the die 100 described above with respect to Figure 1A.

In an embodiment, the die 100 may have a plurality of HBI arrays 116. Each HBI array 116 may be provided over one of the functional blocks 110. That is, the nodes from the underlying functional block 110 may be routed to the HBI pads 115 in the HBI array 116. While shown as a four by four array, it is to be appreciated that the HBI arrays 116 may comprise hundreds or thousands of HBI pads 115.

In an embodiment, the plurality of HBI arrays 116 may all be substantially similar to each other. As such, a single test chiplet may be used to test each of the functional blocks 110. In other embodiments, the HBI arrays 116 may be non-uniform across the die 100. For example, larger functional blocks 110 may include larger HBI arrays 116 in order to provide DFx hooks to more nodes.

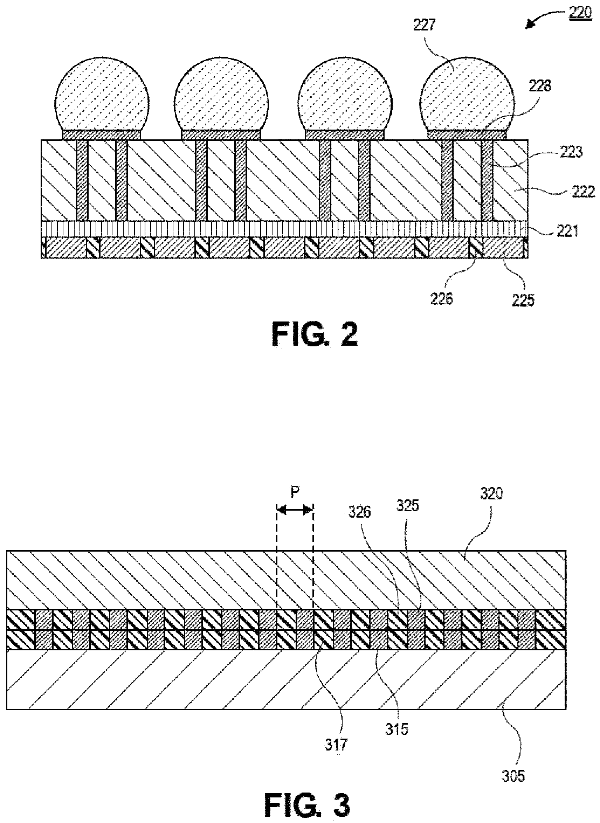

Referring now to Figure 2, a cross-sectional illustration of a test chiplet 220 is shown, in accordance with an embodiment. In an embodiment, the test chiplet 220 may be coupled to a die (not shown) in order to provide testing of one or more functional blocks on the die. In an embodiment, the test chiplet 220 comprises a substrate 222. The substrate 222 may be a silicon substrate or other semiconductor substrate. In an embodiment, through substrate vias (TSVs) 223 pass through a thickness of the substrate 222. In an embodiment, the TSVs 223 end at a backside pad 228. The backside pad 228 may be covered by a solder ball 227. The solder ball 227 may be used to connect the test chiplet 220 to an external device for testing.

In an embodiment, the opposite side of the test chiplet 220 may be the HBI interface. The HBI interface may comprise a plurality of HBI pads 225. The HBI pads 225 may be copper or other conductive material. In an embodiment, the HBI pads 225 are surrounded by a dielectric layer 226. In an embodiment, the dielectric layer 226 may comprise any suitable dielectric material for HBI architectures, such as a dielectric comprising silicon and oxygen (e.g., SiOx). The bottom surface of the dielectric layer 226 and the bottom surface of the HBI pads 225 may be substantially coplanar with each other. In some embodiments, "substantially coplanar" may refer to two surfaces being within approximately 1µm of being coplanar. In other embodiments, the HBI pads 225 may be recessed from the dielectric layer 226. The recess may be approximately 100nm or less, or approximately 10nm or less.

In an embodiment, the HBI pads 225 may be coupled to the TSVs 223 through a routing layer 221. The routing layer 221 may be a passive layer (i.e., with no active transistor circuitry). In other embodiments, the routing layer 221 may be an active layer (i.e., with active transistor circuitry). For example, the routing layer 221 may include circuitry for muxing or otherwise combining multiple HBI pads 225 into a single lane. In an embodiment, the routing layer 221 may also provide circuitry for supporting the testing of the underlying die. For example, the routing layer 221 may include standard testing interfaces used in die testing and debugging.

Referring now to Figure 3, a cross-sectional illustration of a device with a die substrate 305 coupled to a test chiplet 320 is shown, in accordance with an embodiment. In an embodiment, the die substrate 305 may be a silicon substrate or other semiconductor material. Functional blocks (not shown in Figure 3) may be incorporated into the die substrate 305. The die substrate 305 may be similar to any of the dies 100 described in greater detail above. In an embodiment, the test chiplet 320 may also comprise a silicon or other semiconductor substrate. The test chiplet 320 may be substantially similar to the test chiplet 220 described with respect to Figure 2.

In an embodiment, the test chiplet 320 is coupled to the die substrate 305 with an HBI architecture. On the test chiplet 320 side, first pads 325 and a first dielectric layer 326 are provided. In an embodiment, the first pads 325 may comprise copper or any other suitable conductive material, and the first dielectric layer 326 may comprise any suitable dielectric material, such as one comprising silicon and oxygen (e.g., SiOx). On the die substrate 305, second pads 315 and a second dielectric layer 317 are provided. In an embodiment, the second pads 315 may comprise copper or any other suitable conductive material, and the second dielectric layer 317 may comprise any suitable dielectric material, such as one comprising silicon and oxygen (e.g., SiOx).

In an embodiment, the bonding of the test chiplet 320 to the die substrate 305 may be a two part operation. First, at a low temperature, the first dielectric layer 326 bonds to the second dielectric layer 317. Then, at a higher temperature, the first pads 325 bond to the second pads 315. The first pads 325 and the second pads 315 may be bonded together by diffusion bonding processes. In some instances, the diffusion between the bond of the first pads 325 and the second pads 315 may result in there being no discernable interface. As such, it may appear as though there is a single conductive feature between the test chiplet 320 and the die substrate 305.

In an embodiment, the HBI architecture allows for the conductive pads 315 and 325 to have relatively small pitches. For example, a pitch P between conductive pads 325 and 315 may be approximately 20µm or smaller, or approximately 10µm or smaller. In some embodiments, the pitch P may be approximately 1µm or smaller. That is, the pitch P may be at the nanometer scale. Such small pitches allow for the number of DFx hooks to be orders of magnitude more than existing testing architectures. As such, testing and debugging is simplified since more nodes can be viewed without the need for FIB technologies.

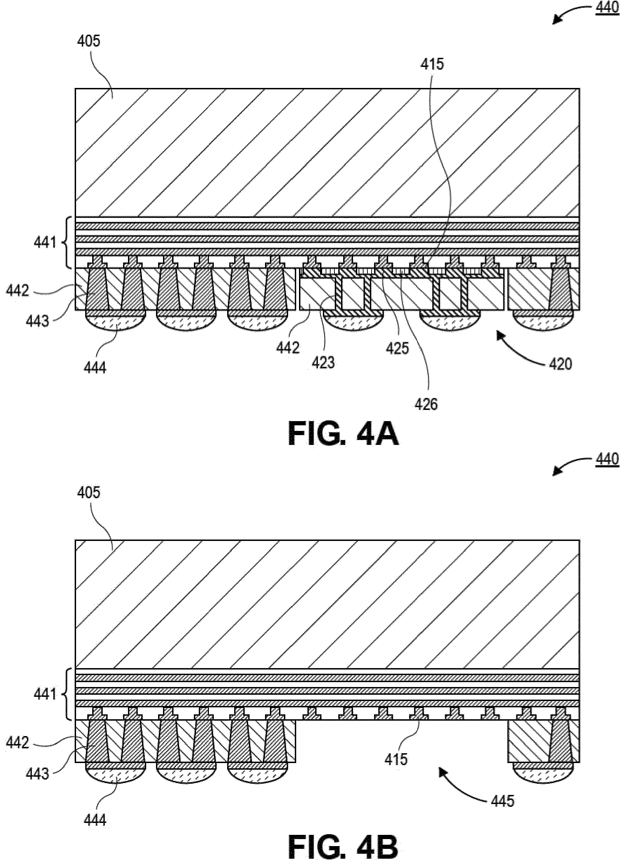

Referring now to Figure 4A, a cross-sectional illustration of a die module 440 is shown, in accordance with an embodiment. In an embodiment, the die module 440 comprises a die substrate 405. The die substrate 405 may be a silicon substrate or another suitable semiconductor material. In an embodiment, the die substrate 405 may be substantially similar to the die substrates 105 described in greater detail above. In an embodiment, routing layers 441 may be provided over a surface of the die substrate 405. As shown, HBI pads 415 may be provided at the surface of the routing layers 441. Some of the HBI pads 415 may be routed to FLIs 444 by vias 443 through a resist layer 442. In other instances, the HBI pads 415 may be coupled to a test chiplet 420.

In an embodiment, the test chiplet 420 may be similar to the test chiplet 220 described in greater detail above. For example, the test chiplet 420 may be an active or passive device. In an embodiment, the test chiplet 420 may comprise HBI pads 425. The HBI pads 425 may be bonded to the HBI pads 415 of the die substrate 405. In an embodiment, the surrounding dielectric layer 426 may also be bonded to the dielectric layer over the routing layers 441 on the die side. In an embodiment, the HBI pads 415 may be electrically coupled to TSVs 423 that pass through the test chiplet 422. The TSVs 423 may be coupled to FLIs 444.

In an embodiment, the test chiplet 420 may persist as part of the final structure of the die module 440. That is, in the device that is ultimately sold to a customer, the test chiplet 420 may be included. Including the test chiplet 420 may be useful for testing units that are returned in order to find out why a device stopped working or otherwise malfunctioned.

However, in other embodiments, the test chiplet 420 may not be present in the final structure of the die module 440. For example, as shown in Figure 4B, a cavity 445 is provided where the test chiplet was positioned. Such an embodiment may occur when the test chiplet 420 is used for debugging and testing purposes, but is not needed during production of the die modules 440. While shown as having a cavity 445, it is to be appreciated that the layer 442 may be continuous across the routing layers 441 and cover the unutilized HBI pads 415. It is to be appreciated that the presence of the HBI pads 415 may be used to indicate that a test chiplet 420 architecture was used. For example, the HBI pads 415 may persist into the units sold to customers. Such units would include HBI pads 415 that seemingly do not connect to any external FLIs 444, or other external connections. That is, during operation of the die 405, some of the HBI pads 415 may be non-functional pads and be electrically floating.

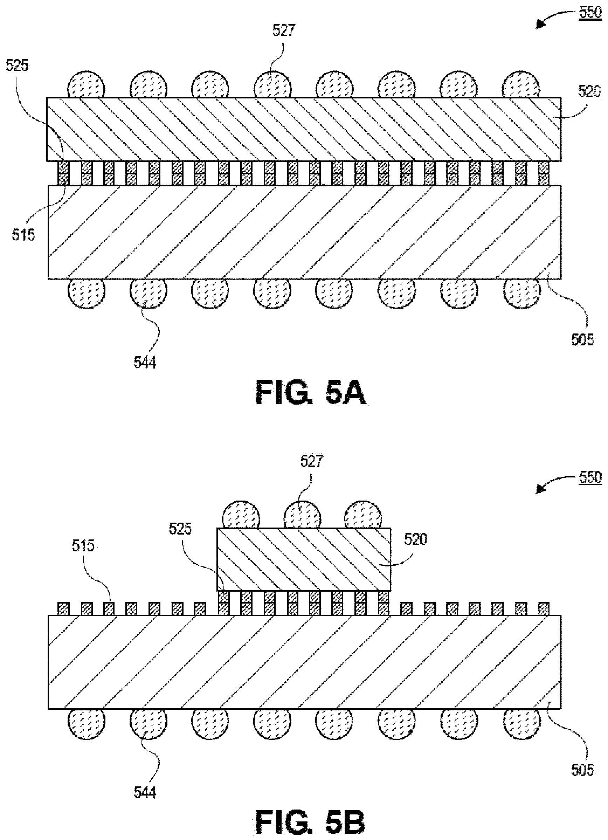

Referring now to Figure 5A, a cross-sectional illustration of a die module 550 is shown, in accordance with an embodiment. In an embodiment, the die module 550 comprises a die substrate 505. The die substrate 505 may be a semiconductor substrate, such as a silicon substrate. The die substrate 505 may also comprise a plurality of functional blocks (not shown). For example, the die substrate 505 may be an SOC or the like. In an embodiment, the die module 550 may further comprise a test chiplet 520. The test chiplet 520 may be an active or passive device used to test or debug nodes within the die substrate 505. The test chiplet 520 may be substantially similar to the test chiplet 220 described with respect to Figure 2.

In an embodiment, the test chiplet 520 is provided on a backside surface of the die substrate 505. That is, the test chiplet 520 is provided on a surface of the die substrate 505 that is opposite from the FLIs 544. This is different than the embodiment described with respect to Figure 4A, where the test chiplet 420 is provided on the FLI side of the die substrate 405. In the illustrated embodiment, the test chiplet 520 has a footprint that substantially matches a footprint of the underlying die substrate 505. In such embodiments, HBI pads 525 of the test chiplet 520 may be coupled to all of the HBI pads 515 of the die substrate 505. That is, a single test chiplet 520 may be used to test all of the populated nodes of the die substrate 505. While twenty two HBI pads 515/525 are shown, it is to be appreciated that hundreds or more, or thousands or more, HBI pads 515/525 may be provided between the test chiplet 520 and the die substrate 505.

As shown, bumps 527 may be provided on the backside of the test chiplet 520. The bumps 527 are for probing the test chiplet 520 during testing and/or debugging. That is, the bumps 527 may not be connected to any other device at the point of sale. Accordingly, the bumps 527 may remain substantially non-functional when left in the final device. By non-functional, embodiments disclosed herein may refer to bumps 527 that are not connected electrically to sockets or other electrical interfaces between substrates in a die module 550.

Referring now to Figure 5B, a cross-sectional illustration of a die module 550 is shown, in accordance with an additional embodiment. The die module 550 may be substantially similar to the die module 550 in Figure 5A, with the exception of the test chiplet 520 having a different form factor. For example, the test chiplet 520 may have a footprint that is substantially smaller than the footprint of the die substrate 505. Such an embodiment may be used when the test chiplet 520 is used to test one of the functional blocks of the die substrate 505. While a single test chiplet 520 is shown, it is to be appreciated that a plurality of test chiplets 520 may be provided on the backside surface of the die substrate 505 in some embodiments. The die module 550 in Figure 5B may result in HBI pads 515 that are not coupled to any external device. As such, some of the HBI pads 515 may be electrically floating in a functioning device.

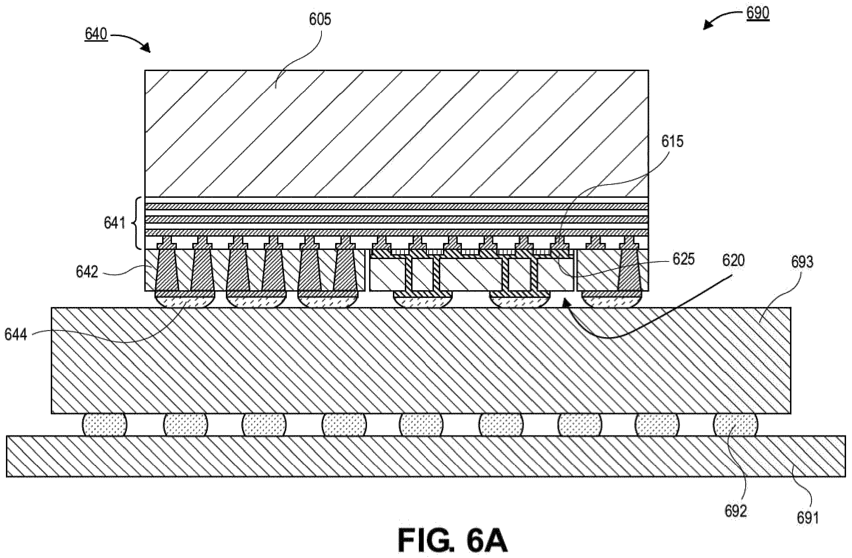

Referring now to Figure 6A, a cross-sectional illustration of an electronic system 690 is shown, in accordance with an embodiment. In an embodiment, the electronic system 690 comprises a board 691. The board 691 may be a printed circuit board (PCB) or the like. In an embodiment, the board 691 is coupled to a package substrate 693 by interconnects 692. In the illustrated embodiment, the interconnects 692 are shown as being solder balls. However, it is to be appreciated that the interconnects 692 may be any second level interconnect (SLI) architecture, such as sockets, wires, or the like. In an embodiment, the package substrate 693 may be an organic substrate formed from a plurality of laminated buildup layers. Package substrate 693 may be cored or coreless. In an embodiment, conductive routing (e.g., pads, traces, vias, etc.) is provided through the package substrate 693.

In an embodiment, a die module 640 is coupled to the package substrate 693. The die module 640 may be coupled to the package substrate 693 by interconnects 644. The interconnects 644 may be FLIs in some embodiments. In an embodiment, the die module 640 comprises a die substrate 605. The die substrate 605 may be a silicon substrate or other semiconductor material. In an embodiment, routing layers 641 may be provided over a surface of the die substrate 605. HBI pads 615 may be provided over the routing layers 641.

In an embodiment, the die module 640 may further comprise a test chiplet 620. The test chiplet 620 may be provided between the die substrate 605 and the package substrate 693. Particularly, the test chiplet 620 may comprise HBI pads 625. The HBI pads 625 may be bonded to the HBI pads 615 of the die substrate 605. The HBI pads 625 may be coupled to FLIs 644 through TSVs through a thickness of the test chiplet 620.

In the illustrated embodiment, the test chiplet 620 is provided between the die substrate 605 and the package substrate 693, similar to the embodiment shown in Figure 4A. However, it is to be appreciated that embodiments are not limited to such architectures. For example, the electronic system 690 may also include test chiplets 620 that are provided on a backside surface of the die substrate 605, similar to embodiments shown in Figures 5A and 5B.

In addition to test chiplets 620 coupled to the die substrate 605, the test chiplets 620 may be coupled to the package substrate 693. In such embodiments, the test chiplet 620 may have access to substantially more embedded memory (either directly integrated or via a high bandwidth attachment to a companion chiplet/microchiplet) than what is cost effective for volume manufacturing. Additionally, a mini-logic analyzer to intelligently digest the transactions that it has visibility to via its enhanced viewport signal connectivity may be provided. This would allow improved debuggability for early versions of the integrated chip/system in package.

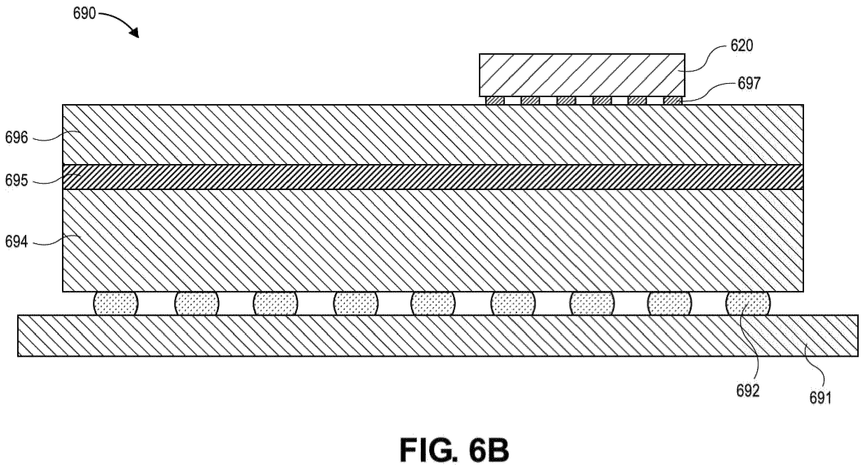

Referring now to Figure 6B, a cross-sectional illustration of an electronic system 690 is shown, in accordance with an additional embodiment. In an embodiment, a board 691 is coupled to a course metal layers 694 by interconnects 692. In the illustrated embodiment, the interconnects 692 are shown as being solder balls (e.g., C4 bumps). In an embodiment, a transistor layer 695 is over the course metal layers, and fine pitch metal layers 696 are provided over the transistor layer 695. In an embodiment, a test chiplet 620 is coupled to the fine pitch metal layers 696 through hybrid bonding 697 or the like.

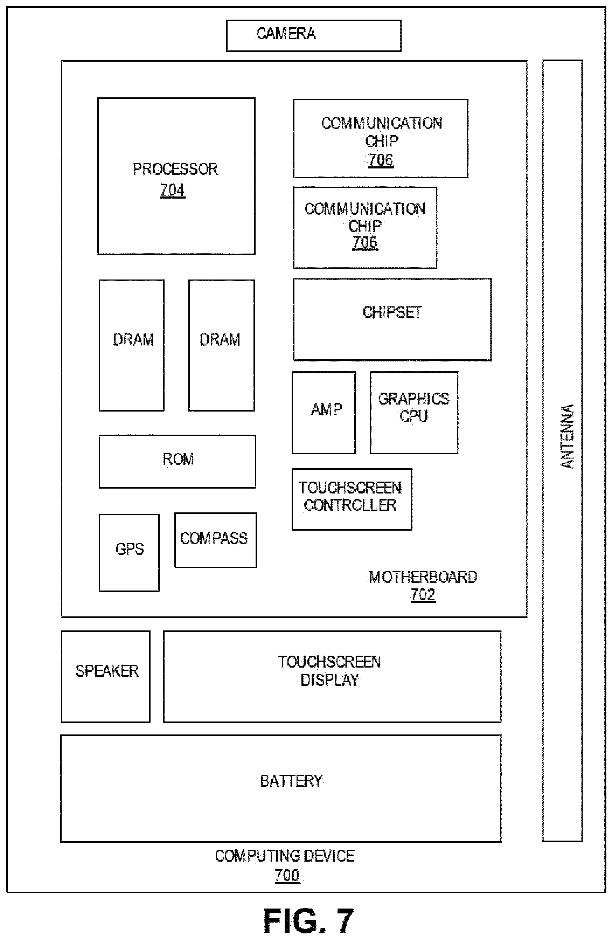

Figure 7 illustrates a computing device 700 in accordance with one implementation of the invention. The computing device 700 houses a board 702. The board 702 may include a number of components, including but not limited to a processor 704 and at least one communication chip 706. The processor 704 is physically and electrically coupled to the board 702. In some implementations the at least one communication chip 706 is also physically and electrically coupled to the board 702. In further implementations, the communication chip 706 is part of the processor 704.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 706 enables wireless communications for the transfer of data to and from the computing device 700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 706 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 700 may include a plurality of communication chips 706. For instance, a first communication chip 706 may be dedicated to shorter range wireless communications such as Wi-Fi and Bluetooth and a second communication chip 706 may be dedicated to longer range wireless communications such as GPS, EDGE, GPRS, CDMA, WiMAX, LTE, Ev-DO, and others.

The processor 704 of the computing device 700 includes an integrated circuit die packaged within the processor 704. In some implementations of the invention, the integrated circuit die of the processor may be part of an electronic package that comprises a die module with base die and a test chiplet coupled to the base die with a HBI architecture, in accordance with embodiments described herein. The term "processor" may refer to any device or portion of a device that processes electronic data from registers and/or memory to transform that electronic data into other electronic data that may be stored in registers and/or memory.

The communication chip 706 also includes an integrated circuit die packaged within the communication chip 706. In accordance with another implementation of the invention, the integrated circuit die of the communication chip may be part of an electronic package that comprises a die module with base die and a test chiplet coupled to the base die with a HBI architecture, in accordance with embodiments described herein.

The above description of illustrated implementations of the invention, including what is described in the Abstract, is not intended to be exhaustive or to limit the invention to the precise forms disclosed. In this respect, the scope of the invention is defined by the appended claims.

## Claims

1. An electronic package (100), comprising:
a package substrate (105);
a die module coupled to the package substrate, wherein the die module comprises:
a die; and
a plurality of chiplets coupled to the die, wherein the plurality of chiplets is formed by chiplets that are coupled to the die with a hybrid bonding interconnect architecture,
wherein the die comprises a plurality of functional blocks (110),
wherein each functional block (110) comprises one of the plurality of chiplets, wherein individual ones of the chiplets are coupled to the respective functional block (110) by the hybrid bonding interconnect architecture,
wherein the hybrid bonding interconnect architecture comprises an array of hybrid bonding interconnect pads (115),
**characterized in that** the array of hybrid bonding interconnect pads (115) is arranged in separate sub-arrays over each of the functional blocks (110), wherein pitch and size of the hybrid bonding interconnect pads (115) are different depending on which functional block (110) the corresponding hybrid interconnect pads (115) are servicing.

2. The electronic package (100) of claim 1, wherein the hybrid bonding interconnect pads (115) comprise first conductive pads surrounded by a first dielectric layer on the die and second conductive pads surrounded by a second dielectric layer on the plurality of chiplets, wherein the first conductive pads are bonded to the second conductive pads.

3. The electronic package (100) of claim 1 or 2, wherein the plurality of chiplets comprise interconnects on a backside surface of the chiplets opposite from the hybrid bonding interconnect architecture.

4. The electronic package (100) of claim 3, wherein the interconnects are electrically floating.

5. The electronic package (100) of claim 3 or 4, further comprising:
through substrate vias through the plurality of chiplets.

6. The electronic package (100) of any one of claims 1 to 5, wherein the plurality of chiplets are on a surface of the die opposite from the package substrate.

7. The electronic package (100) of any one of claims 1 to 6, wherein the plurality of chiplets are between the die and the package substrate.

8. The electronic package (100) of any one of claims 1 to 7, wherein a footprint of the plurality of chiplets is smaller than a footprint of the die.

9. A method of fabricating an electronic package (100), the method comprising:
providing a package substrate (105);
coupling a die module to the package substrate (105), wherein the die module comprises:
a die; and
a plurality of chiplets coupled to the die, wherein the plurality of chiplets is formed by chiplets that are coupled to the die with a hybrid bonding interconnect architecture,
wherein the die comprises a plurality of functional blocks (110),
wherein each functional block (110) comprises one of the plurality of chiplets, wherein individual ones of the chiplets are coupled to the respective functional block (110) by the hybrid bonding interconnect architecture,
wherein the hybrid bonding interconnect architecture comprises an array of hybrid bonding interconnect pads (115), and
**characterized in that** the array of hybrid bonding interconnect pads (115) is arranged in separate sub-arrays over each of the functional blocks (110), wherein pitch and size of the hybrid bonding interconnect pads (115) are different depending on which functional block (110) the corresponding hybrid interconnect pads (115) are servicing.

10. The method of claim 9, wherein the hybrid bonding interconnect pads (115) comprise first conductive pads surrounded by a first dielectric layer on the die and second conductive pads surrounded by a second dielectric layer on the plurality of chiplets, wherein the first conductive pads are bonded to the second conductive pads.

11. The method of claim 9 or 10, wherein the plurality of chiplets comprise interconnects on a backside surface of the chiplets opposite from the hybrid bonding interconnect architecture.

## Patentansprüche

1. Elektronikgehäuse (100), das Folgendes umfasst:
ein Gehäusesubstrat (105);
ein mit dem Gehäusesubstrat verbundenes Die-Modul, wobei das Die-Modul Folgendes umfasst:
einen Die; und
eine Vielzahl von Chiplets, die mit dem Die verbunden sind, wobei die Vielzahl von Chiplets aus Chiplets besteht, die über eine Hybrid-Bonding-Verbindungsarchitektur mit dem Die verbunden sind,
wobei der Die eine Vielzahl von Funktionsblöcken (110) umfasst,
wobei jeder Funktionsblock (110) eines der Vielzahl von Chiplets umfasst, wobei einzelne dieser Chiplets über die Hybrid-Bonding-Verbindungsarchitektur mit dem jeweiligen Funktionsblock (110) verbunden sind,
wobei die Hybrid-Bonding-Verbindungsarchitektur eine Anordnung von Hybrid-Bonding-Verbindungspads (115) umfasst,
**dadurch gekennzeichnet, dass** die Anordnung der Hybrid-Bonding-Verbindungspads (115) in separaten Unteranordnungen über jedem der Funktionsblöcke (110) angeordnet ist, wobei das Rastermaß und die Größe der Hybrid-Bonding-Verbindungspads (115) unterschiedlich sind, je nachdem, welchen Funktionsblock (110) die entsprechenden Hybrid-Bonding-Verbindungspads (115) versorgen.

2. Elektronikgehäuse (100) nach Anspruch 1, wobei die Hybrid-Bonding-Verbindungspads (115) erste leitfähige Pads, die von einer ersten dielektrischen Schicht auf dem Die umgeben sind, und zweite leitfähige Pads, die von einer zweiten dielektrischen Schicht auf der Vielzahl von Chiplets umgeben sind, umfassen, wobei die ersten leitfähigen Pads mit den zweiten leitfähigen Pads verbunden sind.

3. Elektronikgehäuse (100) nach Anspruch 1 oder 2, wobei die Vielzahl von Chiplets Interconnects auf einer Rückseite der Chiplets aufweist, die der Hybrid-Bonding-Verbindungsarchitektur gegenüberliegt.

4. Elektronikgehäuse (100) nach Anspruch 3, wobei die Interconnects elektrisch potentialfrei sind.

5. Elektronikgehäuse (100) nach Anspruch 3 oder 4, das ferner Folgendes umfasst:
Substrat-Durchkontaktierungen durch die Vielzahl von Chiplets.

6. Elektronikgehäuse (100) nach einem der Ansprüche 1 bis 5, wobei sich die Vielzahl von Chiplets auf einer dem Gehäusesubstrat gegenüberliegenden Oberfläche des Dies befindet.

7. Elektronikgehäuse (100) nach einem der Ansprüche 1 bis 6, wobei sich die Vielzahl von Chiplets zwischen dem Die und dem Gehäusesubstrat befindet.

8. Elektronikgehäuse (100) nach einem der Ansprüche 1 bis 7, wobei die Grundfläche der Vielzahl von Chiplets kleiner ist als die Grundfläche des Dies.

9. Verfahren zur Herstellung eines Elektronikgehäuses (100), wobei das Verfahren Folgendes umfasst:
Bereitstellen eines Gehäusesubstrats (105);
Koppeln eines Die-Moduls mit dem Gehäusesubstrat (105), wobei das Die-Modul Folgendes umfasst:
einen Die; und
eine Vielzahl von Chiplets, die mit dem Die verbunden sind, wobei die Vielzahl von Chiplets aus Chiplets besteht, die über eine Hybrid-Bonding-Verbindungsarchitektur mit dem Die verbunden sind,
wobei der Die eine Vielzahl von Funktionsblöcken (110) umfasst,
wobei jeder Funktionsblock (110) eines der Vielzahl von Chiplets umfasst, wobei einzelne dieser Chiplets über die Hybrid-Bonding-Verbindungsarchitektur mit dem jeweiligen Funktionsblock (110) verbunden sind,
wobei die Hybrid-Bonding-Verbindungsarchitektur eine Anordnung von Hybrid-Bonding-Verbindungspads (115) umfasst, und
**dadurch gekennzeichnet, dass** die Anordnung der Hybrid-Bonding-Verbindungspads (115) in separaten Unteranordnungen über jedem der Funktionsblöcke (110) angeordnet ist, wobei das Rastermaß und die Größe der Hybrid-Bonding-Verbindungspads (115) unterschiedlich sind, je nachdem, welchen Funktionsblock (110) die entsprechenden Hybrid-Bonding-Verbindungspads (115) versorgen.

10. Verfahren nach Anspruch 9, wobei die Hybrid-Bonding-Verbindungspads (115) erste leitfähige Pads, die von einer ersten dielektrischen Schicht auf dem Die umgeben sind, und zweite leitfähige Pads, die von einer zweiten dielektrischen Schicht auf der Vielzahl von Chiplets umgeben sind, umfassen, wobei die ersten leitfähigen Pads mit den zweiten leitfähigen Pads verbunden sind.

11. Verfahren nach Anspruch 9 oder 10, wobei die Vielzahl von Chiplets Interconnects auf einer Rückseite der Chiplets aufweist, die der Hybrid-Bonding-Verbindungsarchitektur gegenüberliegt.

## Revendications

1. Boîtier électronique (100), comprenant :
un substrat de boîtier (105) ;
un module de puce couplé au substrat de boîtier, le module de puce comprenant :
une puce ; et
une pluralité de micropuces couplées à la puce, dans lequel la pluralité de micropuces est formée par des micropuces couplées à la puce par une architecture d'interconnexion par collage hybride,
dans lequel la puce comprend une pluralité de blocs fonctionnels (110),
dans lequel chaque bloc fonctionnel (110) comprend l'une de la pluralité de micropuces, dans lequel certaines individuelles des micropuces sont couplées au bloc fonctionnel (110) respectif par l'architecture d'interconnexion par collage hybride,
dans lequel l'architecture d'interconnexion par collage hybride comprend un réseau de plots d'interconnexion par collage hybride (115),
**caractérisé en ce que** le réseau de plots d'interconnexion par collage hybride (115) est agencé en sous-réseaux séparés sur chacun des blocs fonctionnels (110), dans lequel le pas et la taille des plots d'interconnexion par collage hybride (115) sont différents selon le bloc fonctionnel (110) que desservent les plots d'interconnexion hybrides (115) correspondants.

2. Boîtier électronique (100) selon la revendication 1, dans lequel les plots d'interconnexion par collage hybride (115) comprennent des premiers plots conducteurs entourés par une première couche diélectrique sur la puce et des seconds plots conducteurs entourés par une seconde couche diélectrique sur la pluralité de micropuces, dans lequel les premiers plots conducteurs sont collés aux seconds plots conducteurs.

3. Boîtier électronique (100) selon la revendication 1 ou 2, dans lequel la pluralité de micropuces comprend des interconnexions sur une surface arrière des micropuces qui est opposée à l'architecture d'interconnexion par collage hybride.

4. Boîtier électronique (100) selon la revendication 3, dans lequel les interconnexions sont électriquement flottantes.

5. Boîtier électronique (100) selon la revendication 3 ou 4, comprenant en outre :
des traversées de substrat passant à travers la pluralité de micropuces.

6. Boîtier électronique (100) selon l'une quelconque des revendications 1 à 5, dans lequel la pluralité de micropuces se trouve sur une surface de la puce qui est opposée au substrat de boîtier.

7. Boîtier électronique (100) selon l'une quelconque des revendications 1 à 6, dans lequel la pluralité de micropuces est située entre la puce et le substrat de boîtier.

8. Boîtier électronique (100) selon l'une quelconque des revendications 1 à 7, dans lequel une empreinte de la pluralité de micropuces est inférieure à une empreinte de la puce.

9. Procédé de fabrication d'un boîtier électronique (100), le procédé comprenant les étapes consistant à :
fournir un substrat de boîtier (105) ;
coupler un module de puce au substrat de boîtier (105), le module de puce comprenant :
une puce ; et
une pluralité de micropuces couplées à la puce, dans lequel la pluralité de micropuces est formée par des micropuces couplées à la puce par une architecture d'interconnexion par collage hybride,
dans lequel la puce comprend une pluralité de blocs fonctionnels (110),
dans lequel chaque bloc fonctionnel (110) comprend l'une de la pluralité de micropuces, dans lequel certaines individuelles des micropuces sont couplées au bloc fonctionnel (110) respectif par l'architecture d'interconnexion par collage hybride,
dans lequel l'architecture d'interconnexion par collage hybride comprend un réseau de plots d'interconnexion par collage hybride (115), et
**caractérisé en ce que** le réseau de plots d'interconnexion par collage hybride (115) est agencé en sous-réseaux séparés sur chacun des blocs fonctionnels (110), dans lequel le pas et la taille des plots d'interconnexion par collage hybride (115) sont différents selon le bloc fonctionnel (110) que desservent les plots d'interconnexion hybrides (115) correspondants.

10. Procédé selon la revendication 9, dans lequel les plots d'interconnexion par collage hybride (115) comprennent des premiers plots conducteurs entourés par une première couche diélectrique sur la puce et des seconds plots conducteurs entourés par une seconde couche diélectrique sur la pluralité de micropuces, dans lequel les premiers plots conducteurs sont collés aux seconds plots conducteurs.

11. Procédé selon la revendication 9 ou 10, dans lequel la pluralité de micropuces comprend des interconnexions sur une surface arrière des micropuces qui est opposée à l'architecture d'interconnexion par collage hybride.
